# EUROPEAN PATENT SPECIFICATION

(11) **EP 0 770 454 B1**
(45) Date of publication and mention of the grant of the patent: **20.02.2002**
(21) Application number: 96116991.9
(22) Date of filing: 23.10.1996
(51) Int. Cl.: B24B 37/04

(54) **Improvements in or relating to semiconductor wafer fabrication**
Herstellung von Halbleiterwafern
Fabrication de galette semiconductrice

(30) Priority: 23.10.1995 US 5788
(43) Date of publication of application: 02.05.1997
(73) Proprietor: TEXAS INSTRUMENTS INCORPORATED, Dallas Texas 75265 (US)
(72) Inventor: Appel, Andrew Thorton, Dallas, Texas 75214 (US); Chisholm, Michael Francis, Plano, Texas 75203 (US)
(74) Representative: Schwepfinger, Karl-Heinz, Dipl.-Ing.

(56) References cited:
- EP-A- 0 658 400
- WO-A-95/18697
- DE-A- 3 625 286
- US-A- 5 522 965
- US-A- 5 536 202
- US-A- 5 569 062
- PATENT ABSTRACTS OF JAPAN vol. 10, no. 267 (M-516), 11 September 1986 & JP 61 090868 A (TOSHIBA CORP), 9 May 1986,
- PATENT ABSTRACTS OF JAPAN vol. 8, no. 263 (M-342) [1700] , 4 December 1984 & JP 59 134650 A (TOSHIBA K.K.), 2 August 1984,

## Description

### TECHNICAL FIELD OF THE INVENTION

The present invention relates to a method and system for fabricating a semiconductor wafer and, more particularly, to apparatus and system as defined in the precharacterizing portions of claim 1 and claim 15, respectively, and including a method for using the apparatus.

### BACKGROUND OF THE INVENTION

Advances in electronic devices generally include reducing the size of components that form integrated circuits. With smaller circuit components, the value of each unit area on a semiconductor wafer becomes higher because the ability to use all of the wafer area for circuit components improves. As a result of this reduction in size, the line widths patterned on semiconductor wafers have also been reduced. This reduction in line width required a higher global planarity of the imaging surface of the semiconductor wafer than had previously been achievable. In order to improve the overall planarity of a semiconductor wafer a process known as chemical mechanical polish (CMP) has become popular. CMP is a process for improving the surface planarity of a semiconductor wafer and involves the use of mechanical pad polishing systems usually with a silica-based slurry. CMP offers the only practical approach known for achieving an imaging surface with the degree of global wafer planarity required for current multilevel integrated circuits.

Another benefit achieved by CMP was an improvement in the immunity of the wafer to certain types of defects. To properly form an integrated circuit with advanced circuit designs that use higher percentages of the wafer area for smaller components, it is critical that defect counts on the semiconductor wafer be reduced below levels which were previously acceptable for many circuit designs. For example, minute particles of less than 0.2 microns are unacceptable for many of the current advanced circuit designs. This is because the small particles or defects can damage the integrated circuit by shorting out two or more circuit lines or by cutting or otherwise impairing the operation of these circuits.

Current CMP systems for global planarization have certain limitations. A significant limitation of existing CMP systems relates to a part of the system known as the polishing pad. The polishing pad contacts the semiconductor wafer and polishes the wafer. A slurry is usually applied to the polishing pad to lubricate the interface between the wafer and the polishing pad. The slurry also serves the function, because of its silica content, of mildly abrading or affecting the surface of the semiconductor wafer. In addition to the silica, the potassium hydroxide that the slurry contains catalyzes and helps break atomic bonds in the slurry. This further helps to increase the polishing rate for the semiconductor wafer. Most polishing pads are formed of a cellular microstructure polymer material. This material between its cells has numerous voids and pockets that the slurry may fill. As the slurry contacts the semiconductor wafer, it picks up particles and absorbs them.

A problem that often occurs with these particles and the slurry within the cell structure of the pad is a densification of the slurry within the voids. To overcome this problem, most CMP systems use a polishing pad conditioner that rakes or scratches the pad surface to remove the slurry within the pad cellular structure and, in effect, "renew" the polishing pad surface. The pad conditioners are only partially effective because used or contaminated slurry remains within the voids of the polishing pads cellular structure.

Another problem with CMP systems that use pad conditioners of a conventional type is that they are controlled by a robotic arm or other similar mechanism that places the pad conditioner in contact with the polishing pad. These conditioners may be either post polish or in situ systems that typically constitute a computer-controlled robot arm with X-Y movement in an arc and limited Z movement to position the conditioning head and determine downward force. These arms require a mounting plate at the periphery of the polishing platen and a rinse station to clean the head after conditioning. This adds complexity and additional space to the polishing tool as well as additional software control complexity. The post polish conditioners do not correct pad glazing during the duration of the polish. In situ pad conditioners have been cumbersome to implement and can be tool reliability limiters. As they condition the polishing pad the conditioners sweep across the polishing pad to condition the pad prior to the pad contacting the semiconductor wafer. Because of the sweep of the robotic arm and the need to maintain a high degree of prepared surface in contact with the semiconductor wafer, the polishing pad must be large. In many CMP systems, the polishing pad is often many times the area of the semiconductor wafer.

A polishing apparatus or a polishing system, respectively, as defined in the precharacterizing portions of claims 1 and 15 is known from EP-A-0 658 400. The polishing apparatus comprises a polishing section having a turntable with an abrasive cloth mounted on an upper surface thereof, a top ring for supporting a workpiece to be polished and pressing the workpiece against the abrasive cloth, a loading section, for loading the workpiece to be polished onto the top ring, an unloading section for unloading the workpiece which has been polished from the top ring, and a dressing device for dressing the abrasive cloth, and wherein the dressing device is movable between the turntable and a standby section adjacent to the turntable.

These problems with known polishing pads cause polishing rate to vary according to the condition of the polishing pad, which seriously affects and can degrade uniformity. The result is a far less robust polishing process that may even contribute to lower yields in the semiconductor device circuits.

From Patent Abstracts of Japan, volume 10, no. 267 (M-516) it is known to perform dressing of abrasive cloth and polishing of wafers simultaneously by providing the top and rear faces of a carrier plate for holding the wafers with abrasive layers.

### SUMMARY OF THE INVENTION

A need has arisen for an improved CMP system that consumes process materials at a rate substantially lower than the rate of conventional systems.

There is a need for an improved method and system for CMP processing that avoids slurry deposits on the polishing pad more effectively than do current CMP methods and systems.

There is yet a further need for a method and system :that conditions a polishing pad more effectively than do conventional CMP systems and methods and without the abrasive effects of techniques such as those involving the use of sandpaper and diamond scratch devices.

There is still a further need for an improved method and system for CMP processing that allows the use of a smaller diameter polishing pad or at least incorporates a simpler CMP process that eliminates the need for a robotically controlled conditioner having a conditioning surface.

Accordingly, the present invention provides a method for CMP processing of a semiconductor wafer that substantially eliminates or reduces disadvantages and problems associated with previously developed CMP methods and that comprises the steps of claim 8.

Further, the present invention provides an apparatus and a system as mentioned above and comprising the features of the characterizing portions of claims 1 and 15, respectively. In the preferred embodiment, the conditioning surface and wafer area are approximately circular in shape with the conditioning surface generally surrounding the wafer area.

The conditioning surface may be a toothed crystalline-substrate surface having a plurality of teeth that are of a dimensional spacing and size comparable to the dimensional spacing and size of the cell structure of the polishing pad.

Another embodiment of the present invention includes an ultrasonic emitter that directs ultrasonic energy to the polishing pad for dislodging slurry deposits from within and on the polishing pad. In systems where the polishing pad moves relative to the carrier device (i.e., relative motion in the sense that either the polishing pad moves or the carrier device moving, or both), the conditioning surface may condition a selected area on the polishing pad immediately before or after the selected area contacting and polishing the wafer. The conditioning surface may also attach to the carrier device so that when the carrier device rotates or moves during the CMP process, the conditioning surface also rotates or moves at essentially the same rotational speed as does the semiconductor wafer.

A technical advantage of the invention is that it extends the life of a polishing pad. This is in part due to the fact that the carrier device with the conditioning surface more effectively removes slurry deposits that may arise during the CMP process. Because the present invention extends the polishing pad life, the polishing pad cost per wafer decreases. This promotes substantial cost savings in wafer fabrication processes.

Another technical advantage of the present invention is that the conditioning surface preferably surrounds and attaches to the carrier device. This eliminates the need for a robotic arm and end effector that conditions the polishing pad. The elimination of software to control the robotic arm, as well as the electrical and mechanical components of the robotic arm of conventional conditioners, makes possible substantial space savings and a simpler CMP process.

Another technical advantage of the present advantage is that it may incorporate numerous different types of conditioning surfaces. For example, one surface may be a polycrystalline substrate having a plurality of scrubbing teeth, each having a cell structure similar in size to that of the polishing pad cell structure. Alternatively, the conditioning surface may be, for example, an ultrasonic sound source that by ultrasonic sound dislodges spent or used slurry within the polishing pad cell structure as well as from the polishing pad surface. Because the conditioning device can condition the polishing pad immediately after polishing of the semiconductor wafer, slurry does not have an opportunity to deposit and become hard or dense in the polishing pad cellular structure.

Still another technical advantage that the present invention provides is improved polishing pad conditioning uniformity. Improved polishing pad conditioning uniformity produces more uniformly polished semiconductor wafers. Consequently, the yield of the semiconductor devices increases, thereby increasing the overall profitability of the semiconductor drive fabrication process.

### BRIEF DESCRIPTION OF THE DRAWINGS

For a more complete understanding and the advantages thereof, reference is now made to the following description which is to be taken in conjunction with the accompanying drawings in which like reference numerals indicate like features and wherein:
FIGURE 1 shows a chemical mechanical polish (CMP) system for employing the present embodiment of the invention;
FIGURE 2 illustrates a process flow according to the CMP process of the present embodiment;
FIGURE 3 illustrates a photomicrograph of a new polishing pad for polishing a semiconductor wafer;
FIGURE 4 illustrates a polishing pad similar to that of FIGURE 3 after numerous CMP processes that illustrates the deterioration of the pad as well as the glazed areas in the pad microcellular structure;
FIGURES 5 and 6 conceptually illustrate one embodiment of the invention;
FIGURE 7 illustrates a side view of one conditioning surface useable with the present embodiment;
FIGURE 8 illustrates an enlarged cross section of a portion of another embodiment of the present invention; and
FIGURE 9 depicts a cross-sectional view of another embodiment of the present invention.

### DETAILED DESCRIPTION OF ILLUSTRATIVE EMBODIMENTS

Preferred embodiments of the present invention are illustrated in the FIGURES wherein like numerals are used to refer to like and corresponding parts of the various drawings.

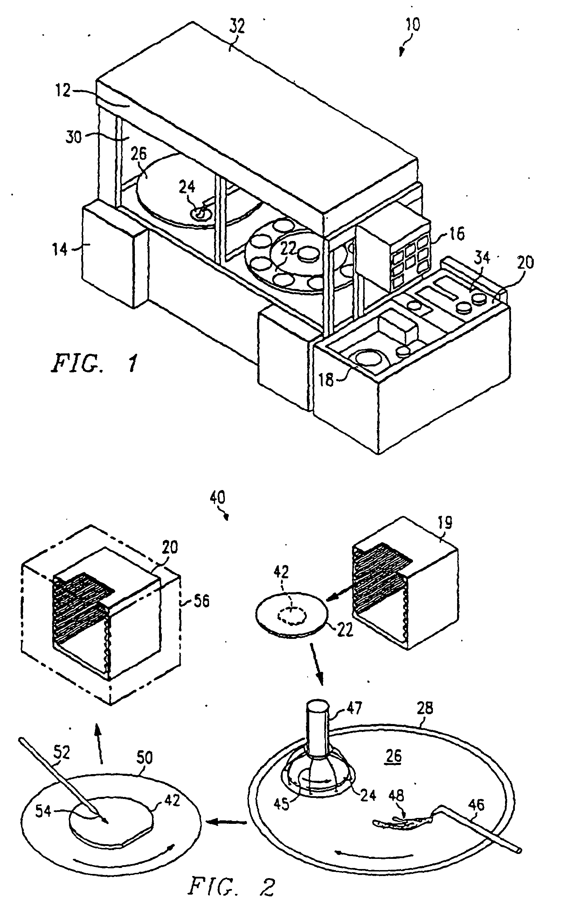

FIGURE 1 shows CMP system 10 that may use the present embodiment of the invention. CMP system includes cabinet 12 on frame 14. Attached to cabinet 12 is touch screen interface 16. Input module 18 and output cassette 20 associate with cabinet 12 for supplying and receiving semiconductor wafers. Frame 14 includes necessary cabinets and access panels for the mechanical and electrical components within cabinet 12, input module 18 and output cassette 20. Cabinet 12 establishes a clean environment in which semiconductor wafers may be transferred to index table 22 which rotates to make accessible a semiconductor wafer to carrier device 24. Carrier device 24 picks up a semiconductor wafer from index table 22 and places it in contact with polishing pad 26. Polishing pad 26 rotates on polishing platen 28. Access doors 30 (normally formed of glass) and filter arrangement 32 isolate the CMP process in cabinet 12 from the external environment. Output wafer track 34 and output cassette 20 work together to receive semiconductor wafers from index table 22 and store these wafers in a deionized water bath.

FIGURE 2 provides process flow 40 to more particularly illustrate that CMP process which the present embodiment supports. Referring to FIGURE 2, process flow 40 begins when semiconductor wafer 42 is removed by CMP system 10 from load cassette 19 which is a part of input module 18. From load cassette 19, semiconductor wafer 42 goes to index table 22 which transfers semiconductor wafer to carrier device 24. From index table 22, semiconductor wafer 42 carrier device 24 picks up which includes conditioning device 44. In the present embodiment, conditioning device 44 surrounds carrier device 24. Although there are many ways to attach conditioning device 44 to carrier device 24, the present embodiment uses attaching mechanism 45 which attaches to arm 47 of carrier device 24.

Arm 47 may work with a control system for controlling the CMP process to assure proper downward force of conditioning device 24 on polishing pad 26. Moreover, carrier device 24 and conditioning device 44 may be associated to permit the application of differing downward forces. Accordingly, conditioning device 44 may apply greater downward force to polishing pad 26 than does carrier device 24, or vice versa, as the polishing requirements of wafer 42 and conditioning requirements of polishing pad 26 differ. A variety of well-known mechanical configurations and techniques can be applied to produce the desired differing downward forces between carrier.

During conditioning, primary platen 28 and polishing pad 26 rotate as a unit. As primary platen 28 and conditioning pad 26 rotate, slurry applicator 46 applies slurry 48 to polishing pad 26. As polishing pad 26 continues to rotate, the portion of polishing pad 26 that just received slurry 48 first comes in contact with conditioning surface 44. Conditioning surface 44 conditions polishing pad 26. Immediately thereafter, the conditioned portion of polishing pad 26 comes in contact with semiconductor wafer 42. Polishing pad 26 then polishes semiconductor wafer 42. Immediately after polishing semiconductor wafer 42, that portion of polishing pad 26 which just contacted semiconductor wafer 42 again contacts conditioning surface 44 for reconditioning. The surface then rotates so that new slurry 48 may be applied by slurry applicator 46.

After conditioning surface 44 conditions polishing pad 26, device 24 transfers semiconductor wafer 42 to final platen 50 where water applicator 52 may apply a water stream 54 to rinse off residual slurry 48 from semiconductor wafer 42. Thereafter, carrier device 24 transfers semiconductor wafer 42 to output cassette 20 within deionized water bath 56 as described and associated with FIGURE 1.

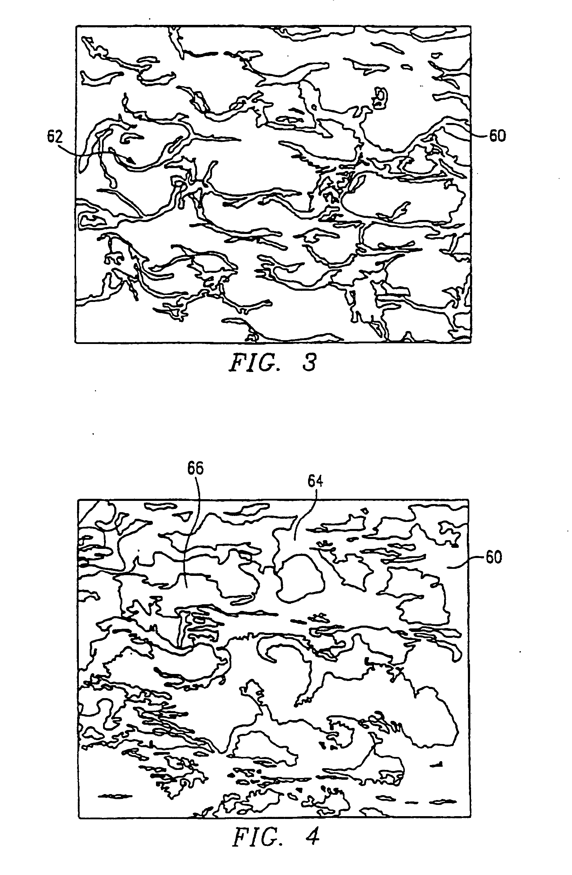

Without the present embodiment, polishing pad 26 becomes clogged with slurry 48 and wafer 42 deposits. These deposits inhibit proper CMP processing. In particular, FIGURES 3 and 4 illustrate a phenomenon that the present embodiment addresses. One example of the FIGURE 3 shows a new polishing pad 26 surface 60 that includes a plurality of microstructure cells 62 that may receive slurry 48 for polishing semiconductor wafer 42. In contrast, FIGURE 4 depicts a polishing pad 26 surface 60 following the polish of approximately one hundred (100) semiconductor wafers 42. As FIGURE 4 depicts, slurry 48 has formed numerous deposits such as deposit 64 and in some instances has filled microstructure cells such as microstructure cell 66. The result of these slurry deposits is a glazing of the polishing pad 26 surface and ultimately the uselessness of polishing pad 26. This significantly increases in the processing costs of the semiconductor wafers.

To remedy the problem that FIGUREs 3 and 4 depict, the present embodiment applies to wafer carrier 24 conditioning device 44.

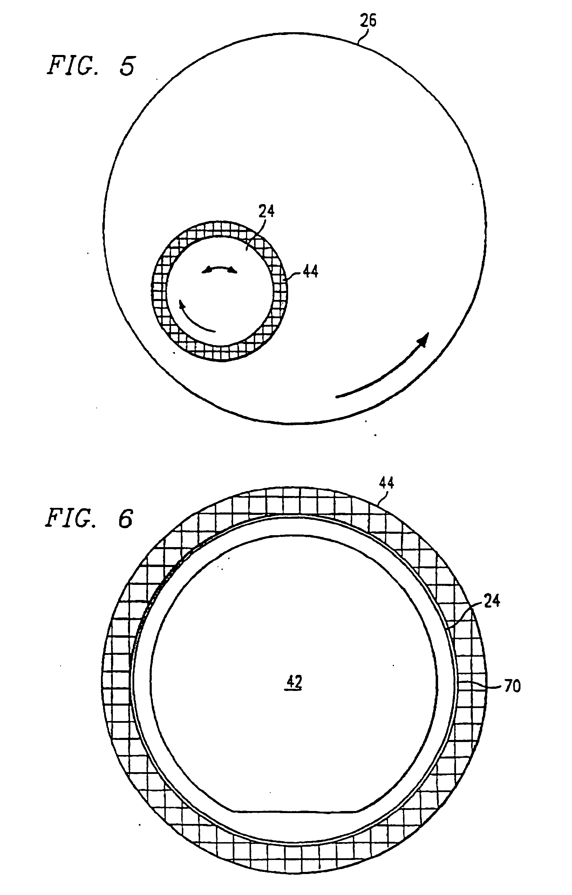

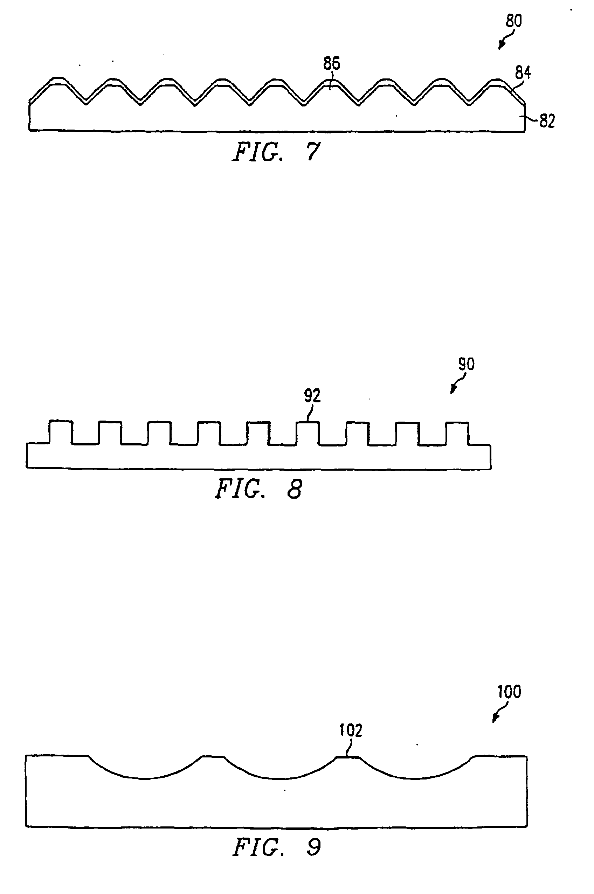

FIGURES 5 and 6 illustrate one system that may include conditioning device 44 in association with carrier device 24. In FIGURE 5, wafer 42 is held in place by carrier device 24. Conditioning ring 44 surrounds carrier device 24. Space 70 between carrier device 24 and conditioning device 44 indicates that conditioning ring 44 is free to rotate relative to carrier device 24 as desired. However, a collar or other mechanism (not shown) may be used to attach conditioning device 44 to carrier device 24. Conditioning device 44 includes a conditioning surface that may take one of several forms as appears in FIGUREs 7, 8, and 9 discussed below. The conditioning device that the present embodiment provides also may take several other forms. Various embodiments of the present invention include incorporating within conditioning device 44 a ring transducer that directs ultrasonic energy into polish pad 26. This will loosen from polish pad 26 slurry deposits and permit unused slurry to be absorbed by polish pad 26.

Instead of or in addition to the use of an ultrasonic transducer mechanism within conditioning device 44, the surface of conditioning device 44 may include crystallographic structures that have a dimension comparable to the microcell structure of a polishing pad. For example, FIGURE 7 shows a cross section of a crystalline structure 80 that may serve as a surface for conditioning device 44 that contacts polish pad 26. In particular, crystallographic structure 80 includes crystalline substrate 82 on which a coating 84 is deposited. Crystalline substrate 82 includes teeth 86 that can nondestructively scrub slurry from the cellular microstructure of polish pad 26.

FIGURE 8 shows another scrubbing surface 90 that may be attached or made part of conditioning device 44. Scrubbing device 90 includes scrubbing teeth 92 that also nondestructively scrub surface 60 of polish pad 26. Still another embodiment of a scrubbing surface for conditioning device 44 appears as scrubbing surface 100 of FIGURE 9. Scrubbing surface 100 may be formed from an amorphous or crystalline substrate and includes the more mildly scrubbing teeth 102 for scrubbing polish pad 26 surface.

The various toothed or rough structures of FIGURES 7, 8 and 9 for the surface of conditioning device 44 may be formed by known semiconductor device fabrication processes such as standard photo lithography and plasma etch processes to etch an amorphous or crystalline substrate. These processes are described in detail in U.S. Patent No.5,536,202 entitled, "Application of Semiconductor Integrated Circuit Fabrication Techniques to the Manufacture of a Conditioning Head Pad Conditioning During Chemical-Mechanical Polish".

In the first method of FIGURE 7, the crystalline substrate is coated with a photo resist to a desired pattern. The second method which FIGURE 8 describes is a plasma definition on amorphous substrate. The FIGURE 9 embodiment is similar to that of FIGURE 7, however, forming embodiment 100 of FIGURE 9 uses an isotropic etch that results in a smoother conditioning feature profile and potentially less physical wear on conditioning pad 26 during conditioning.

Although the invention has been described in detail herein with reference to the illustrative embodiments, it is to be understood that this description is by way of example only and is not to be construed in a limiting sense. For example, the present invention may provide numerous conditioning devices around numerous carrier devices in a single CMP polishing system. Moreover, different forms of teeth on various surfaces for carrier device 44 may be formed and still be within the scope of the present invention.

It is to be further understood that numerous changes in the details of the embodiments of the invention, will be apparent to, and may be made by, persons of ordinary skill in the art having reference to this description.

## Claims

1. An apparatus for chemical-mechanical polishing of a wafer (42), comprising:
a conditioning device (44) having a conditioning surface for conditioning a polishing pad (26); and
a carrier device (24) for holding the wafer (42) **characterized in that** the carrier device (24) is associated with the conditioning device so that the wafer (42) and said conditioning surface may be placed in contact with the polishing pad (26) as a unit for simultaneously conditioning the polishing pad (26) and polishing the wafer (42); and
that said apparatus further comprises an independent control mechanism for independently controlling the downward force of said conditioning device (44) and the downward force of said carrier device (24).

2. The apparatus of Claim 1, wherein said conditioning device (44) is substantially circular, and wherein said carrier device (24) has an appoximately circular area surrounded by said conditioning device (44).

3. The apparatus of Claim 1 or Claim 2, wherein said conditioning device (44) comprises a toothed crystalline-substrate conditioning surface having a plurality of conditioning teeth (86; 92; 102) each comprising dimensional spacing and size comparable to the cell structure dimensions and spacing of the polishing pad (26).

4. The apparatus of any preceding claim, wherein said conditioning device comprises an ultrasonic emitter for directing ultrasonic energy to said polishing pad (26) for dislodging slurry deposits from within the polishing pad cellular structure.

5. The apparatus of any preceding claim, wherein said conditioning device (44) moves relative to the polishing pad (26) and said conditioning device (44) conditions a selected area on the polishing pad (26) immediately prior in time to the time at which said selected area contacts and polishes the wafer (42).

6. The apparatus of any preceding claim, wherein said conditioning device (44) conditions a selected area on the polishing pad (26) immediately following said selected area contacting and polishing the wafer (42).

7. The apparatus of any preceding claim, wherein said conditioning device (44) attaches to the carrier device (24) such that said condition surface rotates in correspondence with the rotation of said carrier device (24).

8. A method for performing a CMP process on a wafer (42), comprising the steps of:
contacting the wafer (42) with a carrier device (24) and a polishing pad (26);
associating a conditioning surface of the carrier with the polishing pad (26) at the same time that the wafer (42) contacts the carrier device (24) and
the polishing pad (26) for simultaneously polishing the wafer (42) with the polishing pad (26) and conditioning the polishing pad (26) with the conditioning surface; and
independently controlling the downward force of the conditioning surface and the downward force of the carrier device (24)

9. The method of Claim 8, further comprising the step of simultaneously polishing the wafer (42) and conditioning the polishing pad (26) with a conditioning region with a conditioning surface that surrounds the wafer (42).

10. The method of Claim 8 or Claim 9, further comprising the step of conditioning the polishing pad (26) with a toothed crystalline-substrate conditioning surface having a plurality of teeth (86; 92; 102), each of said teeth (86; 92; 102) comprising dimensional spacing and size comparable to the cell structure dimensions and spacing of the polishing pad (26).

11. The method of any of Claims 8 to 10, further comprising the step of conditioning the polishing pad (26) by directing ultrasonic energy to the polishing pad (26) to dislodge slurry deposits from within and on the polishing pad (26).

12. The method of any of Claims 6 to 11, wherein the polishing step comprises moving the polishing pad (26) relative to the wafer (42) and conditioning a predetermined area of the polishing pad (26) immediately prior in time to the time at which selected area contacts and polishes the wafer (42).

13. The method of any of Claims 8 to 12, wherein the polishing step comprises moving the polishing pad (26) relative to the wafer (42) and conditioning a selected area of the polishing pad (26) at a time immediately following the time at which the selected area contacts and polishes the wafer (42).

14. The method of any of Claims 8 to 13, further comprising rotating the carrier device (24) at a selected speed and in a selected direction relative to the polishing pad (26), and rotating the conditioning surface in association with the carrier device (24).

15. A CMP system for polishing a wafer (42), comprising:
a carrier device (24) for holding the wafer (42);
a platen (28) for rotating at a predetermined speed and direction;
a polishing pad (26) associated with said platen (28) for polishing the wafer (42);
means (46) for applying a slurry coating (48) for lubricating said polishing pad (26) as the wafer (42) contacts the polishing pad (26) and further for mildly abrading and polishing the wafer (42); and
a conditioning device (44) for conditioning the polishing pad (26) **characterized in that**
said carrier device (24) holds the wafer (42) and comprises the conditioning device (44) so that the wafer (42) and a conditioning surface of said conditioning device (44) contact said polishing pad (26) for simultaneously conditioning said polishing pad (26) and polishing the wafer (42); and that said CMP system further comprises an independent control mechanism for independently controlling the downward force of said conditioning device (44) and
the downward force of said carrier device (24).

16. The system of Claim 15, further comprising a plurality of said carrier devices (24) for simultaneously polishing a plurality of wafers (42) on said polishing pad (26) while separately and simultaneously conditioning each position on said polishing pad (26) associated with each of said plurality of wafers (42).

17. The system of Claim 15 or Claim 16, wherein said conditioning surface is an approximately annular disk and further wherein said carrier device (24) is an approximately circular disk nestled within said conditioning surface.

18. The system of any of Claims 15 to 17, wherein said conditioning surface comprises a toothed crystalline-substrate conditioning surface having a plurality of teeth (86; 92; 102) each comprising a dimensional spacing and size comparable to the dimensional spacing and size of the cell structure od said polishing pad (26).

19. The system of any of Claims 15 to 18, wherein said conditioning surface comprises an ultrasonic emitter for directing ultrasonic energy to said polishing pad (26) for dislodging slurry deposits from within and on said polishing pad (26).

20. The system of any of Claims 15 to 19, wherein said carrier device (24) rotates and further wherein an attaching mechanism attaches said conditioning surface to the carrier device (24) such that, as said carrier device (24) rotates, said conditioning surface rotates in association with said carrier device (24).

## Patentansprüche

1. Gerät zum chemisch-mechanischen Polieren einer Halbleiterscheibe (42), mit:
einer Aufbereitungsvorrichtung (44) mit einer Aufbereitungsfläche zum Aufbereiten eines Polierkissens (26); und einer Trägervorrichtung (24) zum Halten der Halbleiterscheibe (42), **dadurch gekennzeichnet, daß** die Trägervorrichtung (24) mit der Aufbereitungsvorrichtung so in Verbindung steht, daß die Halbleiterscheibe (42) und die Aufbereitungsfläche in Kontakt mit dem Polierkissen (26) als Einheit gebracht werden können, um gleichzeitig das Polierkissen (26) aufzubereiten und die Halbleiterscheibe (42) zu polieren; und daß das Gerät ferner einen unabhängigen Steuermechanismus enthält, um die abwärts gerichtete Kraft der Aufbereitungsvorrichtung (44) und die abwärts gerichtete Kraft der Trägervorrichtung (24) unabhängig zu kontrollieren.

2. Gerät nach Anspruch 1, bei dem die Aufbereitungsvorrichtung (44) im wesentlichen kreisförmig ist und bei dem die Trägervorrichtung (24) einen angenähert kreisförmigen Bereich aufweist, der von der Konditionierungsvorrichtung (44) umgeben ist.

3. Gerät nach Anspruch 1 oder Anspruch 2, bei dem die Aufbereitungsvorrichtung (44) eine gezahnte Kristallsubstrat-Aufbereitungsfläche mit mehreren Aufbereitungszähnen (86; 92; 102) aufweist, die jeweils mit der Abstands- und Größendimension mit den Zellstrukturabmessungen und dem Abstandsmaß des Polierkissens (26) vergleichbar sind.

4. Gerät nach einem der vorhergehenden Ansprüche, bei dem die Aufbereitungsvorrichtung einen Ultraschallsender zum Lenken von Ultraschallenergie zu dem Polierkissen (26) umfaßt, um Schlammablagerungen aus der Zellstruktur des Polierkissens zu beseitigen.

5. Gerät nach einem der vorhergehenden Ansprüche, bei dem sich die Aufbereitungsvorrichtung (44) relativ zum Polierkissen (26) bewegt und die Aufbereitungsvorrichtung (44) einen ausgewählten Bereich des Polierkissens (26) unmittelbar vor dem Zeitpunkt aufbereitet, an dem der ausgewählte Bereich die Halbleiterscheibe (42) berührt und poliert.

6. Gerät nach einem der vorhergehenden Ansprüche, bei dem die Aufbereitungsvorrichtung (44) einen ausgewählten Bereich an dem Polierkissen (26) aufbereitet, unmittelbar nach dem der ausgewählte Bereich die Halbleiterscheibe (42) berührt und poliert hat.

7. Gerät nach einem der vorhergehenden Ansprüche, bei dem die Aufbereitungsvorrichtung (44) so an der Trägervorrichtung (24) befestigt ist, daß die Aufbereitungsfläche entsprechend der Rotation der Trägervorrichtung (24) rotiert.

8. Verfahren zur Durchführung eines CMP-Prozesses an einer Halbleiterscheibe (42), mit den Schritten:
Berühren der Halbleiterscheibe (42) mit einer Trägervorrichtung (24) und einem Polierkissen (26);
Verbinden einer Aufbereitungsfläche des Trägers mit dem Polierkissen (26) am gleichen Zeitpunkt, an dem die Halbleiterscheibe (42) die Trägervorrichtung (24) und das Polierkissen (26) poliert, damit gleichzeitig die Halbleiterscheibe (42) mit dem Polierkissen (26) poliert und das Polierkissen (26) mit der Aufbereitungsfläche aufbereitet wird; und
unabhängiges Steuern der nach unten gerichteten Kraft der Aufbereitungsfläche und der nach unten gerichteten Kraft der Trägervorrichtung (24).

9. Verfahren nach Anspruch 8, bei dem ferner gleichzeitig die Halbleiterscheibe (42) poliert und das Polierkissen (26) mit einer Aufbereitungszone mit einer Aufbereitungsfläche aufbereitet, die die Halbleiterscheibe (42) umgibt.

10. Verfahren nach Anspruch 8 oder Anspruch 9, bei dem ferner das Polierkissen (26) mit einer gezahnten Kristallsubstrat-Aufbereitungsfläche aufbereitet wird, die mehrere Zähne (86; 92; 102) aufweist, wobei jeder der Zähne (86; 92; 102) Abstands- und Größendimensionen hat, die mit den Zellstrukturabmessungen und dem Abstandsmaß des Polierkissens (26) vergleichbar sind.

11. Verfahren nach einem der Ansprüche 8 bis 10, bei dem ferner das Polierkissen (26) aufbereitet wird, indem Ultraschallenergie auf das Polierkissen (26) gelenkt wird, um Schlammablagerungen zu beseitigen, die sich in und auf dem Polierkissen (26) befinden.

12. Verfahren nach einem der Ansprüche 8 bis 11, bei dem ferner das Polierkissen (26) relativ zur Halbleiterscheibe (42) bewegt wird und ein vorbestimmter Bereich des Polierkissens (26) unmittelbar vor dem Zeitpunkt aufbereitet wird, an dem der ausgewählte Bereich die Halbleiterscheibe (42) berührt und poliert.

13. Verfahren nach einem der Ansprüche 8 bis 12, bei dem der Polierschritt das Bewegen des Polierkissens (26) relativ zur Halbleiterscheibe (42) sowie das Aufbereiten eines ausgewählten Bereichs des Polierkissens (26) an einem unmittelbar auf den Zeitpunkt folgenden Zeitpunkt, an dem der ausgewählte Bereich die Halbleiterscheibe (42) berührt und poliert, umfaßt.

14. Verfahren nach einem der Ansprüche 8 bis 13, bei dem ferner die Trägervorrichtung (24) mit einer ausgewählten Drehzahl und in einer ausgewählten Richtung relativ zum Polierkissen (26) gedreht wird und die Aufbereitungsfläche zusammen mit der Trägervorrichtung (24) gedreht wird.

15. CMP-System zum Polieren einer Halbleiterscheibe (42), mit:
einer Trägervorrichtung (24) zum Halten der Halbleiterscheibe (42);
einer sich mit einer vorbestimmten Drehzahl und Richtung drehenden Auflageplatte (28);
einem mit der Auflageplatte (28) verbundenen Polierkissen (26) zum Polieren der Halbleiterscheibe (42);
Mittel (46) zum Aufbringen einer Schlammschicht (48) zum Schmieren des Polierkissens (26), wenn die Halbleiterscheibe (42) das Polierkissen (26) berührt und ferner zum milden Abschleifen und Polieren der Halbleiterscheibe (42); und
einer Aufbereitungsvorrichtung (44) zum Aufbereiten des Polierkissens (26)
**dadurch gekennzeichnet,**
**daß** die Trägervorrichtung (24) die Halbleiterscheibe (42) so hält und die Aufbereitungsvorrichtung (44) enthält, so daß die Halbleiterscheibe (42) und eine Aufbereitungsfläche der Aufbereitungsvorrichtung (44) das Polierkissen (26) berühren, um gleichzeitig das Polierkissen (26) aufzubereiten und die Halbleiterscheibe (42) zu polieren; und daß das CMP-System ferner einen unabhängigen Steuermechanismus umfaßt, um die abwärts gerichtete Kraft der Aufbereitungsvorrichtung (44) und die abwärts gerichtete Kraft der Trägervorrichtung (24) unabhängig zu steuern.

16. System nach Anspruch 15, ferner mit mehreren Trägervorrichtungen (24) zum gleichzeitigen Polieren mehrerer Halbleiterscheiben (42) auf dem Polierkissen (26) während der getrennten und gleichzeitigen Aufbereitung jeder Position an dem Polierkissen (26), die jeder der mehreren Halbleiterscheiben (42) zugeordnet ist.

17. System nach Anspruch 15 oder Anspruch 16, bei dem die Aufbereitungsfläche eine angenähert ringförmige Scheibe ist und bei dem ferner die Trägervorrichtung (24) eine angenähert kreisförmige Scheibe ist, die innerhalb der Aufbereitungsfläche sitzt.

18. System nach einem der Ansprüche 15 bis 17, bei dem die Aufbereitungsfläche eine gezahnte Kristallsubstrat-Aufbereitungsfläche mit mehreren Zähnen (86; 92; 102) umfaßt, die jeweils Abstands- und Größendimensionen haben, die mit der Abstandsabmessung und der Größe der Zellenstruktur des Polierkissens (26) vergleichbar sind.

19. System nach einem der Ansprüche 15 bis 18, bei dem die Aufbereitungsfläche einen Ultraschallsender zum Lenken von Ultraschallenergie zu dem Polierkissen (26) umfaßt, um Schlammablagerungen zu beseitigen, die sich in und auf dem Polierkissen (26) befinden.

20. System nach einem der Ansprüche 15 bis 19, bei dem die Trägervorrichtung (24) rotiert und bei dem ferner ein Befestigungsmechanismus die Aufbereitungsfläche an der Trägervorrichtung (24) so befestigt, daß die Aufbereitungsfläche dann, wenn die Trägervorrichtung (24) rotiert, zusammen mit der Trägervorrichtung (24) rotiert.

## Revendications

1. Appareil de polissage mécanique et chimique d'une galette (42), comportant:
- un dispositif de conditionnement ayant une surface de conditionnement pour conditionner une pastille (26) de polissage ; et un dispositif de transport (24) pour tenir la galette (42) **caractérisé en ce que** le dispositif de transport (24) est associé avec le dispositif de conditionnement de manière à ce que la galette (42) et ladite surface de conditionnement peuvent être placées en contact avec la pastille de polissage (26) comme une seule unité pour, simultanément, conditionner la pastille de polissage (26) et polir la galette (42) ; et **en ce que** ledit appareil comporte en outre un mécanisme de commande indépendant pour contrôler indépendamment la force vers le bas dudit dispositif de conditionnement (44) et la force vers le bas dudit dispositif de transport (24).

2. Appareil selon la revendication 1, dans lequel ledit dispositif de conditionnement (44) est sensiblement circulaire, et dans lequel ledit dispositif de transport (24) a une aire approximativement circulaire entourée par ledit dispositif de conditionnement (44).

3. Appareil selon la revendication 1 ou 2, dans lequel ledit dispositif de conditionnement (44) comporte une surface de conditionnement dentée formée dans un substrat cristallin, ladite surface ayant plusieurs dents de conditionnement (86 ; 92 ; 102) comprenant chacune un écartement et une taille de dimensions comparables aux dimensions de la structure de cellule et aux écartements de la pastille de polissage (26).

4. Appareil selon l'une quelconque des revendications précédentes, dans lequel ledit dispositif de conditionnement comporte un émetteur d'ultrasons pour diriger l'énergie ultrasonique vers ladite pastille de polissage (26) pour déloger les dépôts de déchets de l'intérieur de la structure cellulaire de la pastille de polissage.

5. Appareil selon l'une quelconque des revendications précédentes, dans lequel ledit dispositif de conditionnement (44) se déplace par rapport à la pastille de polissage (26) et ledit dispositif de conditionnement (44) conditionne une aire sélectionnée sur la pastille de polissage (26) immédiatement avant l'instant auquel ladite aire sélectionnée entre en contact et polit la galette (42).

6. Appareil selon l'une quelconque des revendications précédentes, dans lequel ledit dispositif de conditionnement (44) conditionne une aire sélectionnée sur la pastille de polissage (26) immédiatement après que ladite aire sélectionnée entre en contact et polit la galette (42).

7. Appareil selon l'une quelconque des revendications précédentes, dans lequel ledit dispositif de conditionnement (44) est attaché au dispositif de transport (24) de manière à ce que ladite surface de conditionnement tourne en association avec la rotation dudit dispositif de transport (24).

8. Procédé pour réaliser un procédé CMP sur une galette (42), comprenant :
- une étape de mise en contact de la galette (42) avec un dispositif de transport (24) et avec une pastille de polissage (26) ;
- une étape d'association d'une surface de conditionnement du transporteur avec la pastille de polissage (26) au même moment où la galette (42) entre en contact avec le dispositif de transport (24) et la pastille de polissage (26) pour, simultanément, polir la galette (42) avec la pastille de polissage (26) et conditionner la galette de polissage (26) avec la surface de conditionnement ; et
- une étape de contrôle de la force vers le bas de la surface de conditionnement et de la force vers le bas du dispositif de transport (24) indépendamment l'une de l'autre.

9. Procédé selon la revendication 8, comprenant en outre l'étape de, simultanément, polir la galette (42) et conditionner la pastille de polissage (26) avec une région de conditionnement ayant une surface de conditionnement qui entoure la galette (42).

10. Procédé selon la revendication 8 ou 9, comprenant en outre l'étape de conditionner la pastille de polissage (26) avec une surface de conditionnement dentée formée dans un substrat cristallin, ladite surface ayant une pluralité de dents (86 ; 92 ; 102), chacune desdites dents (86 ; 92 ; 102) comportant un écartement et une taille de dimensions comparables aux dimensions de la structure de cellule et aux écartements de la pastille de polissage (26).

11. Procédé selon l'une quelconque des revendications 8 à 10, comprenant en outre l'étape de conditionner la pastille de polissage (26) en dirigeant une énergie ultrasonique vers la pastille de polissage (26) pour déloger les dépôts de déchets de l'intérieur et sur la pastille de polissage (26).

12. Procédé selon l'une quelconque des revendications 6 à 11, dans lequel l'étape de polissage comporte une étape de déplacement de la pastille de polissage (26) par rapport à la galette (42) et de conditionnement d'une aire prédéterminée de la pastille de polissage (26) immédiatement avant en terme de temps à l'instant auquel l'aire sélectionnée entre en contact et polit la galette (42).

13. Procédé selon l'une quelconque des revendications 8 à 12, dans lequel l'étape de polissage comprend une étape de déplacement de la pastille de polissage (26) par rapport à la galette (42) et de conditionnement d'une aire sélectionnée de la pastille de polissage (26) à un instant immédiatement après l'instant auquel l'aire sélectionnée entre en contact et polit la galette (42).

14. Procédé selon l'une quelconque des revendications 8 à 13, comprenant en outre l'étape d'entraîner en rotation le dispositif de transport (24) à une vitesse sélectionnée et dans une direction sélectionnée par rapport à la galette de polissage (26) et entraîner en rotation la surface de conditionnement en association avec le dispositif de transport (24).

15. Système CMP pour polir une galette (42), comportant
- un dispositif de transport (24) pour tenir la galette (42) ;
- une platine (28) apte à tourner à une vitesse et dans une direction prédéterminées ;
- une pastille de polissage (26) associée avec ladite platine (28) pour polir la galette (42) ;
- des moyens (46) pour appliquer un revêtement (48) de déchets pour lubrifier ladite pastille de polissage (26) lorsque la galette (42) entre en contact avec la pastille de polissage (26) et en outre pour, légèrement, abraser et polir la galette (42) ; et
- un dispositif de conditionnement (44) pour conditionner la pastille de polissage (26)
**caractérisé en ce que** ledit dispositif de transport (24) tient la galette (42) et comporte le dispositif de conditionnement (44) de manière à ce que la galette (42) et une surface de conditionnement dudit dispositif de conditionnement (44) entrent en contact avec la pastille de polissage (26) pour, simultanément, conditionner ladite pastille de polissage (26) et polir la galette (42) ; et **en ce que** ledit système CMP comprend en outre un mécanisme de commande indépendant pour contrôler indépendamment la force vers le bas dudit dispositif de conditionnement (44) et la force vers le bas dudit dispositif de transport (24).

16. Système selon la revendication 15, comprenant en outre plusieurs dispositifs de transport (24) pour polir simultanément plusieurs galettes (42) sur ladite pastille de polissage (26) pendant que, séparément et simultanément, conditionner chaque position sur ladite pastille de polissage (26) associée avec chacune desdites plusieurs galettes (42).

17. Système selon la revendication 15 ou 16, dans lequel ladite surface de conditionnement est approximativement un disque annulaire et en outre dans lequel ledit dispositif de transport (24) est approximativement un disque circulaire logé à l'intérieur de la surface de conditionnement.

18. Système selon l'une quelconque des revendications 15 à 17, dans lequel ladite surface de conditionnement comporte une surface de conditionnement dentée formée dans un substrat cristallin, ladite surface ayant plusieurs dents (86 ; 92 ; 102) comportant chacune un écartement et une taille de dimensions comparables aux dimensions de l'écartement et de la taille de la structure de cellule de ladite pastille de polissage (26).

19. Système selon l'une quelconque des revendications 15 à 18, dans lequel ladite surface de conditionnement comporte un émetteur ultrasonique pour diriger une énergie ultrasonique vers la pastille de polissage (26) pour déloger les dépôts de déchets de l'intérieur et sur ladite pastille de polissage (26).

20. Système selon l'une quelconque des revendications 15 à 19, dans lequel ledit dispositif de transport (24) tourne et en outre dans lequel un mécanisme d'attache attache ladite surface de conditionnement au dispositif de transport (24) de telle manière que, comme ledit dispositif de transport (24) tourne, ladite surface de conditionnement tourne en association avec ledit dispositif de transport (24).
